## Europäisches Patentamt
## European Patent Office
## Office européen des brevets

(11) Veröffentlichungsnummer : **0 053 259**
**B1**

(12) **EUROPÄISCHE PATENTSCHRIFT**

(45) Veröffentlichungstag der Patentschrift :
**28.12.83**

(21) Anmeldenummer : **81108478.9**

(22) Anmeldetag : **19.10.81**

(51) Int. Cl.³ : **G 03 C   1/80**, G 03 C   1/68,
G 03 C   1/70, G 03 C   1/727,
G 03 F   7/02, G 03 F   7/16//
B41N1/06, B41N1/12

(54) **Lichtempfindliches Mehrschichtenmaterial und Verfahren zur Herstellung von Haftschichten dafür.**

(30) Priorität : **03.12.80 DE 3045516**

(43) Veröffentlichungstag der Anmeldung :
**09.06.82 Patentblatt 82/23**

(45) Bekanntmachung des Hinweises auf die Patenterteilung : **28.12.83 Patentblatt 83/52**

(84) Benannte Vertragsstaaten :
**BE CH DE FR GB IT LI NL**

(56) Entgegenhaltungen :
**Keine**

(73) Patentinhaber : **BASF Aktiengesellschaft
Carl-Bosch-Strasse 38
D-6700 Ludwigshafen (DE)**

(72) Erfinder : **Bronstert, Bernd, Dr.
Sonnenstrasse 12B
D-6710 Frankenthal (DE)**
Erfinder : **Hahn, Herbert, Dr.
Ungsteiner Strasse 41
D-6700 Ludwigshafen (DE)**
Erfinder : **Hoffmann, Gerhard, Dr.
Pappelstrasse 22
D-6701 Otterstadt (DE)**
Erfinder : **Lenz, Werner, Dr.
Heinrich-Baermann-Strasse 14
D-6702 Bad Duerkheim (DE)**

Lichtempfindliches Mehrschichtenmaterial und Verfahren zur Herstellung von Haftschichten dafür

Die Erfindung betrifft lichtempfindliche Mehrschichtenmaterialien, die zwischen einem Träger und einer lichtempfindlichen Schicht mit einem Polyamid-Bindemittel und fotopolymerisierbaren ethylenisch ungesättigten Verbindungen spezielle Haftschichten aufweisen sowie ein Verfahren zur Herstellung solcher Haftschichten.

Es ist z. B. aus der DE-A-15 97 515 bekannt, zur verbesserten Haftung einer lichtempfindlichen Schicht auf Trägern Grundierlacke mit hydroxylgruppenhaltigen Bindemitteln und Polyisocyanaten zu verwenden. Aus der DE-A-22 02 357 ist ferner bekannt, zur weiteren Verbesserung der Haftung auf die erste Haftschicht aus dem Grundierlack (GL) einen Oberlack (OL) zur Erzeugung einer weiteren Haftschicht aufzubringen und hierfür eine Mischung eines härtbaren Phenol-Formaldehyd-Harzes mit einem alkohollöslichen Polyamid-Bindemittel zu verwenden, die zur Bildung der weiteren Haftschicht eingebrannt, d. h. gehärtet wird. Oft zeigen aus solchen Mehrschichtenmaterialien hergestellte Reliefdruckformen insbesondere bei freistehenden Punkten und feinen Linien eine tonnenförmige Reliefstruktur mit einer schlechten Versockelung auf dem Trägermaterial. So sind oft japanische Schriftelemente schwierig einwandfrei damit zu drucken. Auch sind hierbei die langen Belichtungszeiten zur Eliminierung von Unterwaschungseffekten bei der Entwicklung der Reliefformen unbefriedigend.

Der vorliegenden Erfindung lag die Aufgabe zugrunde, lichtempfindliche Mehrschichtenmaterialien für die Herstellung von Reliefformen durch eine Änderung der Haftschichten so zu verbessern, daß ohne Verschlechterung der Haftungseigenschaften eine verbesserte Reliefstruktur und eine verbesserte Versockelung freistehender Punkte (pyramidenförmiger Aufbau) bei der bekannten Verarbeitung dieser Mehrschichtenmaterialien zu Reliefformen und insbesondere Reliefdruckformen resultiert.

Es wurde nun gefunden, daß diese Aufgabe gelöst werden kann, wenn auf den Träger (T) erst ein Grundierlack (GL) aufgetragen wird, der neben einem Epoxidharz-Bindemittel mit einem mittleren Molekulargewicht von 900 bis 25 000 und einem Hydroxylgruppen-Gehalt von 4 bis 8 Gew.% sowie der 0,8 bis 2fach äquivalenten Menge an Polyisocyanat, eine Pigmentkombination einer überwiegenden Menge eines Zinksulfid-Weißpigments, das bis zu 50 Gew.% durch Magnesiumoxid ersetzt sein kann, mit einer kleineren Menge eines Titandioxid-Weißpigments und bevorzugt Chromoxidgrün-Pigment, als Feststoffe enthält, und nach dem Trocknen und Einbrennen der Grundierhaftschicht (HG) ein Oberlack (OL) aufgetragen wird, der als Bindemittel eine Mischung aus 65 bis 98 Gew.% eines alkohollöslichen Copolyamids und 2 bis 35 Gew.% eines härtbaren alkoholveretherten Melamin-Formaldehyd-Kondensats mit einem mittleren Molekulargewicht von 300 bis 1 800 enthält, wobei der Oberlack vor dem Aufbringen der lichtempfindlichen reliefbildenden Schicht (R) eingebrannt wird.

Gegenstand der Erfindung ist neben dem Verfahren zur Herstellung der Haftschichten eines solchen Mehrschichtenmaterials somit ein lichtempfindliches Mehrschichtenmaterial, das

a) zwischen einem Träger (T) und

b) einer lichtempfindlichen Schicht (R) mit einer Fotoinitiator enthaltenden in alkoholischem Lösungsmittel löslichen oder dispergierbaren Mischung von mindestens einem Polyamid-Bindemittel und mindestens einer damit verträglichen fotopolymerisierbaren ethylenisch ungesättigten Verbindung,

c) eine dem Träger (T) benachbarte pigmentierte Haftschicht (HG) mit einem Umsetzungsprodukt eines hydroxylgruppenhaltigen Bindemittels mit einem Polyisocyanat und

d) eine den Schichten (HG) und (R) benachbarte Haftschicht (HO) mit einer eingebrannten Mischung eines Polyamid-Bindemittels, das mit dem Polyamid-Bindemittel der Schicht (R) verträglich ist, und einem härtbaren Formaldehyd-Harz
aufweist, das dadurch gekennzeichnet ist, daß

A) die Haftschicht (HG) durch Auftragen, Trocknen und Einbrennen eines Grundierlackes (GL) hergestellt ist, der als Feststoffe enthält :

A1) 20 bis 60 Gew.%, bezogen auf die Menge an Feststoffen A1-A4 eines Epoxidharz-Bindemittels mit einem mittleren Molekulargewicht von 900 bis 25 000 und einem Hydroxylgruppen-Gehalt von 4 bis 8 Gew.%,

A2) 0,8 bis 2 Äquivalente, bezogen auf 1 Äquivalent Hydroxylgruppen von (A1), eines Polyisocyanats,

A3) 15 bis 35 Gew.%, bezogen auf die Menge an Feststoffen A1-A4, einer Pigmentkombination aus

A3.1) einem Zinksulfid-Weißpigment, das bis zu 50 Gew.% durch Magnesiumoxid ersetzt sein kann,

A3.2) 0,05 bis 10 Gew.% der Pigmentkombination (A3) eines Titandioxid-Weißpigments, und

A3.3) 0 bis 10 Gew.% der Pigmentkombination (A3) Chromoxidgrün-Pigment,

A4) 0 bis 25 Gew.%, bezogen auf die Menge an Feststoffen A1-A4, mindestens eines Extenders, und

B) die Haftschicht (HO) als Bindemittel eine eingebrannte Mischung aus

B1) 65-98 Gew.% eines alkohollöslichen Copolyamids und

B2) 2 bis 35 Gew.% eines härtbaren alkoholverätherten Melamin-Formaldehyd-Kondensats mit einem mittleren Molekulargewicht von 300 bis 1 800
enthält.

Dimensionsstabile Träger (T) sind bevorzugt metallische Trägerbleche wie Stahl- oder Aluminiumbleche in bekannten Stärken. Auf die Stahlbleche kann eine Zinn-, Chrom- oder Nickelschicht aufgebracht sein. Bevorzugt sind sauer entfettete und anschließend phosphatierte oder chromatisierte Stahlbleche und entfettete und danach chromatisierte Aluminiumbleche. Für manche Verwendungen sind auch dimensionsstabile Folien als Träger geeignet wie Polyesterfolien.

Als lichtempfindliche Schicht R — auch Fotopolymerschicht R genannt — enthalten die erfindungsgemäßen Mehrschichtmaterialien im wesentlichen eine Fotoinitiator enthaltende, in alkoholischem Lösungsmittel lösliche oder dispergierbare Mischung von mindestens einem Polyamid-Bindemittel und mindestens einer damit verträglichen fotopolymerisierbaren ethylenisch ungesättigten Verbindung. Geeignete Polyamid-Bindemittel sind z. B. alkohollösliche Copolymerisate, wie sie z. B. in der FR-A-15 20 856 der der DE-A-22 02 357 beschrieben sind und deren entsprechende unbelichtete Polyamid-Monomer-Mischungen mit wäßrigem Alkohol, wie mit Wasser-Äthanol- oder Wasser-Propanol-Mischungen ausgewaschen werden können.

Als fotopolymerisierbare ethylenisch ungesättigte Verbindungen für die Schicht R sind vor allem die niedermolekularen Verbindungen mit mindestens einer ethylenisch ungesättigten fotopolymerisierbaren Doppelbindung geeignet, soweit sie mit den jeweils gewählten polymeren Bindemitteln verträgliche Mischungen bilden und einen Siedepunkt von über 100 °C bei Atmosphärendruck haben. Bevorzugt sind Monomere mit zwei oder mehr ethylenisch ungesättigten fotopolymerisierbaren Doppelbindungen allein oder deren Mischungen mit Monomeren mit nur einer ethylenisch ungesättigten fotopolymerisierbaren Doppelbindung.

Geeignet sind neben Di- und Polyacrylaten und -methacrylaten, wie sie durch Veresterung von Diolen oder Polyolen mit Acrylsäure oder Methacrylsäure hergestellt werden können, wie Di- und Tri(meth)-acrylate von Äthylenglykol, Diäthylenglykol, Triäthylenglykol, Polyäthylenglykol mit einem Molekulargewicht bis etwa 500, 1,2-Propandiol, 1,3-Propandiol, Neopentylglykol (2,2-Dimethyl-propandiol), 1,4-Butandiol, 1,1,1-Trimethylolpropan, Glycerin oder Pentaerythrit, besonders solche Monomere, die zusätzlich zu den Doppelbindungen noch Amid- und/oder Urethangruppen enthalten wie Derivate von Acrylamiden, z. B. die Umsetzungsprodukte von 2 Mol N-Hydroxymethyl(meth)-acrylamid mit 1 Mol eines aliphatischen Diols, wie Äthylenglykol, Xylylen-bis-acrylamid oder Alkylen-bis-acrylamide mit 1 bis 8 C-Atomen im Alkylenrest. Das Mengenverhältnis in der Mischung von Monomeren und polymerem Bindemittel ist in weitem Umfang variierbar, es beträgt bevorzugt 10 bis 55 und insbesondere 25 bis 50 Gew.% an Monomeren und 45 bis 90 und insbesondere 50 bis 75 Gew.% an polymerem Bindemittel, bezogen auf die Summe der Mengen von Monomeren und polymeren Bindemitteln. Im allgemeinen sind die Schichten R bei Raumtemperatur fest.

Die verwendete Menge an Fotoinitiator hängt von seinem Extinktionskoeffizienten und der Schichtdicke der Materialien bei der Härtung ab und beträgt im allgemeinen 0,01 bis 15 Gew.%, insbesondere etwa 0,01 bis 5 Gew.% der Gesamtmenge der Schicht R. Als Fotoinitiator sind praktisch alle Verbindungen geeignet, die bei Einwirkung von aktinischem Licht Radikale zu bilden vermögen, die eine Polymerisation auslösen. Als Fotoinitiatoren kommen z. B. in Frage Acyloine und Acyloinether, aromatische Diketone und deren Derivate, mehrkernige Chinone, Acridinderivate, Phenazinderivate oder Benzoyl-phosphinoxide. Sehr geeignet sind Benzoin und α-Hydroxymethylbenzoin sowie deren Alkylether mit 1 bis 8 C-Atomen wie Benzoin-isopropylether, α-Hydroxymethyl-benzoinmethylether, Benzointetrahydropyranylether oder Benzoinmethyl-ether, Benzilmonoketale wie Benzil-monomethyl-benzylketal oder Benzil-mononeopentylketal.

Die Mischungen für die Schicht R können auch weitere übliche Zusätze enthalten wie Weichmacher, gesättigte niedermolekulare Verbindungen mit Amidgruppen, Wachse, Aktivatoren, thermische Polymerisationsinhibitoren usw. in den an sich bekannten Mengen.

Die erfindungsgemäße, dem Träger (T) benachbarte Haftschicht (HG) wird durch Auftragen und Trocknen bzw. Einbrennen eines Grundierlacks (GL) hergestellt und hat im allgemeinen danach eine Schichtstärke von 3 bis 100 und bevorzugt 5 bis 30 μm. Als Epoxidharz-Bindemittel mit einem mittleren Molekulargewicht von 900 bis 25 000 und insbesondere von 3 000 bis 11 000 und einem Hydroxylgruppengehalt von 4 bis 8 und insbesondere 4,5 bis 7,2 Gew.%, sind bevorzugt in organischen Lösungsmitteln lösliche lineare, aromatische Gruppen in der Kette enthaltende Epoxidharze, insbesondere aus Bisphenol-A und Epichlorhydrin hergestellte hydroxylgruppenhaltige Produkte. Beispielsweise seien genannt handelsübliche Epoxidharze, hergestellt aus Bisphenol-A und Epichlorhydrin, die ein Epoxidäquivalent von ca. 0,055 (bezogen auf 100 g Harz), ein OH-Gehalt von 6,1 Gew.% und ein Molekulargewicht von 2 900 aufweisen ; aus den gleichen Komponenten hergestellte Epoxidharze mit einem Epoxidäquivalent von ca. 0,03 (bezogen auf 100 g Harz), einem OH-Gehalt von 6,8 Gew.% und einem Molekulargewicht von 3 700 bis 3 800 oder ebensolche handelsüblichen Produkte mit Epoxidäquivalenten von 0,02 bis 0,04 (bezogen auf 100 g Harz), OH-Gehalten von 5,2 bis 5,5 Gew.% und Molekulargewichten von ca. 5 500 bis 9 000.

Die Menge an Epoxidharz-Bindemittel im Grundierlack GL beträgt zweckmäßigerweise 20 bis 60 und insbesondere 25 bis 45 Gew.%, bezogen auf die Summe der Feststoffe A1-A4.

Als Polyisocyanate (A2) zur Polyurethanbildung, d. h. als Härter des Bindemittels (A1), kommen freie als auch sogenannte verkappte Polyisocyanate oder Isocyanat-Abspalter (vgl. z. B. Houben-Weyl, Methoden der organischen Chemie, 4. Auflage, Band XIV/2, Seite 61, G. Thieme Verlag, Stuttgart 1963) in Frage, vorzugsweise Polyisocyanate mit 2 oder mehr aromatisch gebundenen Isocyanatgruppen.

Beispiele sind Toluylen-2,4/2,6-diisocyanat (TDI) als freies Isocyanat oder z. B. verkappt mit Phenol; Diphenylmethan-4,4'-diisocyanat (MDI); Naphthylen-1,5-diisocyanat (NDI); 3,3'-Dimethyldiphenyl-4,4'-diisocyanat (TODI); das Umsetzungsprodukt von 3 Molen Toluylendiisocyanat (TDI) mit 1 Mol 1,1,1-Trimethylolpropan als freies Triisocyanat oder etwa verkappt mit Methyläthylketonoxim oder Dibutylmalonat; das Umsetzungsprodukt von 3 Molen TDI mit 1 Mol Thiophosphorsäure; Triphenylmethantriisocyanat; das Dimere von Toluylendiisocyanat; die Oligomeren aus 5 Molen und 7 Molen Toluylendiisocyanat mit jeweils 2 und 3 Isocyanuratringen.

Für die Umsetzung mit dem Bindemittel A1 werden 0,8 bis 2 und bevorzugt 1 bis 1,3 Äquivalente an Isocyanat pro Äquivalent an Hydroxylgruppe in dem Bindemittel A1 angewandt.

Der erfindungsgemäß für die Haftschicht HG verwandte Grundierlack GL enthält ferner 15 bis 35 und insbesondere 15 bis 25 Gew.% der Summe der Feststoffe A1 bis A4 einer Pigmentkombination aus bevorzugt mehr als 90 Gew.% eines Zinksulfid-Weißpigments (wie Zinksulfid oder bevorzugt Lithopone), das bis zu 50 Gew.% und insbesondere bis zu 20 Gew.% durch Magnesiumoxid ersetzt sein kann, 0,05 bis 10 und insbesondere 1,5 bis 4 Gew.% Titandioxid-Weißpigment wie Rutil oder Anatas und 0 bis 10 und insbesondere 2 bis 4,5 Gew.% Chromoxidgrün-Pigment. Eine sehr geeignete Pigmentkombination besteht z. B. aus ca. 94 Gew.% Lithopone (mit einem Zinksulfid-Gehalt von 60 Gew.%), ca. 2 Gew.% Rutil und ca. 4 Gew.% Chromoxidgrün. Als sehr zweckmäßig hat sich gezeigt, wenn das Gewichtsverhältnis von Epoxidharz-Bindemittel (A1) zur Pigmentkombination (A3) 1 : 1 bis 2 : 1 und insbesondere etwa 1,4 bis 1,6 : 1 beträgt.

Der Grundierlack GL kann ferner bis zu 25 Gew.%, bezogen auf die Feststoffe A1-A4, eines Extenders (A4) oder einer Extendermischung (A4) enthalten. Günstig hat sich ein Extendergehalt von 10 bis 20 und insbesondere von 14 bis 16 Gew.% erwiesen. Zur Definition von Extendern (englisch : extender pigments) oder Füllstoffen sei auf P. Nylen und E. Sunderland, Modern Surface Coatings, Interscience Publishers, London-New York-Sydney 1965, Section 13.42, Seiten 461-473 und die DIN-Norm 55945 verwiesen. Sie unterscheiden sich von den Pigmenten (A3) insbesondere durch ihren niedrigen Brechungsindex und ihr geringes Deckvermögen. Gut bewährt haben sich als Extender Talkum und Bentonite sowie die handelsüblichen durch Kationenaustausch zwischen Bentoniten und organischen Ammoniumbasen modifizierten Bentonite.

Für die erfindungsgemäß verwendeten Grundierlacke GL für die Haftschicht HG kommen als weitere Zusatzstoffe übliche Dispergier- und Absetzverhinderungsmittel in Frage. Falls gewünscht, kann bei der Herstellung der Haftschicht HG die Aushärtung und Verankerung des Grundierlackes auch durch Zusatz üblicher Katalysatoren für die Polyisocyanathärtung beschleunigt werden. Solche Beschleuniger sind z. B. tertiäre Amine, die in Mengen von etwa 0,005-1 Gew.% zugesetzt werden, sowie Schwermetallsalze wie Zinn- und Zinksalze von Monocarbonsäuren, die in Mengen von etwa 0,001-1 Gew.% zugesetzt werden, wobei sich die Prozentangaben auf den Feststoffgehalt im Grundierlack bezieht.

Die Herstellung der Haftschicht HG erfolgt durch Auftragen des Grundierlackes GL, der durch Abmischen bzw. Lösen der Feststoffkomponenten und Reaktanten in Lösungsmitteln erhalten wird. Geeignete Lösungsmittel für den Grundierlack sind Gemische aus aromatischen Lösungsmitteln wie Toluol, Xylol und Cumol; Glykolestern wie Methylglykolacetat, Äthylglykolacetat, Butylglykolacetat; Glykolethern wie Diglykoldimethylether; Estern, wie Butylacetat, Amylacetat und Butoxyl und Ketonen wie Methyläthylketon, Methylisobutylketon, Diisobutylketon, Cyclohexanon und Diacetonalkohol.

Zur Herstellung der erfindungsgemäßen Haftschicht HG wird der fertig abgemischte Grundierlack auf einen entsprechend vorbehandelten Träger (T) in einer solchen Stärke aufgebracht, daß eine Trockenschichtstärke von 3-100 µm, vorzugsweise 5-30 µm erzielt wird. Die Beschichtung kann mit Hilfe einer der üblichen Techniken wie Streichen, Spritzen, Tauchen, Gießen oder Walzenauftrag erfolgen. Danach wird die Beschichtung je nach Trägertyp bei Temperaturen zwischen 50 und 300 °C, vorzugsweise zwischen 100 und 230 °C, während eines Zeitraumes von einer Minute bis zu mehreren Stunden, vorzugsweise in 2-60 Minuten getrocknet und eingebrannt. Dies kann z. B. in einem geeigneten Umlufttrockenschrank erfolgen. Vor dem Einbrennen wird zweckmäßigerweise 2-60 Minuten bei Temperaturen zwischen Raumtemperatur und 100 °C abgelüftet bzw. vorgetrocknet.

Die erfindungsgemäße spezielle Haftschicht (HG) auf dem Träger (T) dient primär der Haftvermittlung zum Träger. Durch eine weitere Haftschicht (HO), d. h. Aufbringen einer weiteren Oberlackschicht wird dann die Haftung zwischen der Haftschicht HG und der lichtempfindlichen Monomer-Polymer-Schicht R verbessert. Erfindungsgemäß eignen sich als Materialien für den Oberlack (OL) für die Herstellung der oberen Haftschicht HO härtbare Mischungen von (B1) 65 bis 98 und insbesondere 80 bis 92 Gew.% eines alkohollöslichen Copolyamids, das mit dem Polyamid-Bindemittel der Schicht R verträglich ist, und (B2) 2 bis 35 und insbesondere 8 bis 20 Gew.% eines härtbaren alkoholveretherten Melamin-Formaldehyd-Kondensats mit einem mittleren Molekulargewicht von 300 bis 1 800 und insbesondere 300 bis 1 200. Vorteilhaft ist es, als Copolyamid solche zu verwenden, wie sie für die reliefbildende lichtempfindliche Schicht R oben angegeben sind. Bevorzugt wird ein gleiches oder strukturell sehr ähnliches Copolyamid für die Haftschicht HO wie für die Schicht R angewandt. Als härtbare alkoholverätherte Melamin-Formaldehyd-Kondensate des angegebenen Molekulargewichts eignen sich besonders handelsübliche Produkte wie sie durch saure Kondensation von Melamin mit überschüssigen Mengen an Formaldehyd in Gegenwart von niederen Alkoholen oder durch Verätherung oder Umätherung von polyfunktionellen Methylolmelamin-Kondensaten hergestellt werden können. Besonders bewährt haben sich mit $C_1$-$C_4$-

Alkanolen verätherte Melamin-Formaldehyd-Kondensate. Als Katalysatoren zur schnelleren Härtung können Säuren und Säureabspalter zugesetzt werden, z. B. Ameisensäure oder Essigsäure.

Zur Herstellung der oberen Haftschicht HO wird bevorzugt die Mischung als 15-25 %ige Lösung (etwa in Propanol/Wasser) so aufgetragen, daß die Trockenfilmdicke 7-50 μm beträgt. Die Vortrocknung der Schicht kann wie bei der Herstellung der Grundierhaftschicht HG erfolgen, das Einbrennen wird vorzugsweise bei 90-230 °C je nach Trägertyp während 3 bis 60 Minuten durchgeführt.

Zur weiteren Herstellung der erfindungsgemäßen lichtempfindlichen Mehrschichtenmaterialien werden auf den mit der erfindungsgemäßen Haftschicht HG und zusätzlich mit der Oberlackschicht HO versehenen Träger (T) die Fotopolymerschichten R mit Vorteil aufkaschiert, wobei vorzugsweise Propanol-Wasser-Mischungen als Kaschierlösungsmittel eingesetzt werden. Die erhaltenen fotoempfindlichen Rohplatten bzw. erfindungsgemäßen Mehrschichtenmaterialien zeigen nicht nur eine ausgezeichnete Haftung der Fotopolymerschicht R auf den Trägern (T), sondern bei ihrer Verarbeitung zu Reliefformen werden für freistehende Reliefpunkte und andere feine Reliefstrukturen besonders vorteilhafte Versockelungen und Reliefflankenwinkel erzielt, die bei Verwendung als Reliefdruckformen besonders vorteilhafte Druckergebnisse zeigen.

Die erfindungsgemäßen Mehrschichtenmaterialien eignen sich besonders zur Herstellung von Reliefdruckformen. Die Platten lassen sich z. B. in bekannter Weise zu Druckklischees verarbeiten, indem sie nach evtl. nicht-bildmäßiger Vorbelichtung (ohne Vernetzung der lichtempfindlichen Schicht R) durch ein geeignetes Negativ bildmäßig belichtet, durch Auswaschen mit einem geeigneten Lösungsmittelgemisch entwickelt und gegebenenfalls nicht-bildmäßig nachbelichtet und getrocknet werden. Zur Vorbelichtung, Bildbelichtung und Nachbelichtung eignen sich die üblichen aktinische Strahlung emittierenden Lichtquellen wie Kohlenbogenlampen, Quecksilberdampflampen, Xenonlampen oder Leuchtstoffröhren. Die Plattenentwicklung kann durch Aufsprühen des Lösungsmittels mit Hilfe eines geeigneten Düsensystems oder durch Ausreiben mit Plüsch oder geeigneten Bürsten, aufgebracht auf rotierenden und/oder oszillierenden Tellern, Walzen und Bändern im Lösungsmittel durchgeführt werden. Die Klischeetrocknung bzw. Nachhärtung erfolgt am zweckmäßigsten durch Aufblasen von Heißluft und/oder Beaufschlagung mit Infrarotstrahlung.

Die in den nachstehenden, die Erfindung erläuternden Beispielen und Vergleichsversuchen angegebenen Teile und Prozente beziehen sich, soweit nicht anders angegeben, auf das Gewicht.

## Beispiel 1

### 1.1 Herstellung der Haftschicht HG

243 Teile eines handelsüblichen Epoxidharzes (hergestellt aus Bisphenol A und Epichlorhydrin) mit einem Epoxidäquivalent von ca. 0,02 (bezogen auf 100 g Harz), einem Molekulargewicht von ca. 5 500 und einem OH-Gehalt von 5,9 % (Komponente A1), sowie 147 Teile feinteiliges Lithopone (ZnS-Gehalt 60 %), 3 Teile feinteiliges Rutil, 6 Teile feinteiliges Chromoxidgrün, 90 Teile Talkum und 20 Teile einer handelsüblichen Paste eines mit organischen Ammoniumbasen modifizierten Bentonits (Bentone[R] der Fa. National Lead Co.) werden mit Butylacetat, Äthylglykolacetat und Xylol in einer Kugelmühle 2 Tage lang angerieben.

In den resultierenden Stammlack werden 346 Teile eines handelsüblichen Umsetzungsproduktes aus 1 Mol 1,1,1-Trimethylolpropan und 3 Molen Toluylendiisocyanat als Polyisocyanat (A3) in Form der 75 %igen Lösung in Xylol/Äthylglykolacetat (Teilverhältnis 1 : 1) eingemischt.

Der resultierende Lack wird auf ein Aluminiumblech schichtförmig aufgegossen. Die Lackschicht wird 1 h bei Raumtemperatur abgelüftet und danach 5 min im Umlufttrockenschrank bei 180 °C eingebrannt. Die Trockenfilmstärke der resultierenden Grundierlackschicht (Haftschicht HG) beträgt ca. 18 μm.

### 1.2 Herstellung der Oberlackschicht HO

341 Teile eines Copolyamids aus etwa gleichen Teilen Hexamethylendiammoniumadipat, 4,4'-Diammonium-dicyclohexylmethanadipat und ε-Caprolactam mit einem K-Wert (Fikentscher, Cellulosechemie 13 (1932) 58) von 67 sowie 65 Teile eines handelsüblichen, härtbaren methanolveretherten Melamin-Formaldehyd-Kondensats mit einem mittleren Molekulargewicht von etwa 400 (hergestellt durch Reaktion von Melamin mit überschüssigem Formaldehyd in Gegenwart von Methanol in schwach saurem Medium) werden in Alkohol bei 50 °C gelöst. Mit einem Gießer wird die Lösung so auf das mit der Haftschicht HG versehene Trägerblech schichtförmig aufgetragen, daß eine Trockenfilmdicke von ca. 8 μm resultiert. Nach ca. 30 min Ablüften bei Raumtemperatur wird 4 min im Umlufttrockenschrank bei 145-160 °C eingebrannt.

### 1.3 Auftragen der lichtempfindlichen Schicht R

Einer 65 %igen Lösung eines Gemischs von 60 % des unter 1.2 angegebenen Copolyamids, 25 % des Diäthers aus 1 Mol Äthylenglykol und 2 Molen N-Hydroxymethylacrylamid, 13,5 % Benzolsulfonamid und

**0 053 259**

1,5 % Benzointetrahydropyranyläther werden 0,3 % des Kaliumsalzes des N-Nitrosocyclohexylhydroxylamins, 0,01 % eines schwarzen Farbstoffs (Color-Index Nr. 12195) und 0,03 % 2-Butylthio-2-anthrachinon zugegeben. Die Lösung wird schichtförmig auf das gemäß 1.1 und 1.2 mit den haftschichten versehene Aluminiumblech so aufgegossen, daß nach dem Trocknen bei etwa 70 °C eine lichtempfindliche Schicht R mit einer Stärke von 680 μm entsteht.

### 1.4 Prüfung der Mehrschichtenmaterialien

Das Mehrschichtenmaterial wird bildmäßig belichtet und die Mindestbelichtungszeit bestimmt, die zur guten Ausbildung eines freistehenden Reliefpunktes von 200 μm Durchmesser im Negativ erforder-lich ist. Sie beträgt 3,5 min. Die Versockelungswinkel α (gemessen vom Träger zur Tangente an den Reliefpunkt an der Versockelung) und Flankenwinkel β (gemessen von der Ebene der druckenden Fläche zur Tangente an den Reliefpunkt im Schnittpunkt mit der druckenden Ebene) für die freistehenden Reliefpunkte des Oberflächendurchmessers 200 μm betragen 90° und 59 ± 2°. Zur ausreichenden Versockelung der Punkte sind Versockelungswinkel α von mindestens 90° anzustreben.

### Beispiel 2

Es wird wie in Beispiel 1 verfahren, jedoch enthält die lichtempfindliche Schicht R anstelle des Benzolsulfonamids das Reaktionsprodukt von 1 Mol Toluylendiisocyanat mit 2 Molen 2-Hydroxyethylmethacrylat. Die Mindestbelichtungszeit gemäß 1.4 beträgt 10 min, der Versockelungswinkel etwa 90° und der Flankenwinkel 59 ± 2 °C.

### Vergleichsversuch 1

Es wird exakt wie in Beispiel 1 verfahren, jedoch wird zur Herstellung der Oberlackschicht HO gemäß 1.2 statt des Melamin-Formaldehyd-Harzes die gleiche Menge eines härtbaren Phenolharzes (hergestellt durch Kondensation von 30 Teilen Phenol und 7,5 Teilen Bisphenol A mit überschüssigem Formaldehyd bei 100 °C in Gegenwart von Dimethylethanolamin) verwandt.

Die Mindestbelichtungszeit gemäß 1.4 beträgt 4,5 min, der Versockelungswinkel ca. 90 °C.

Wird wie in Beispiel 1 nur 3,5 min belichtet, so beträgt der Versockelungswinkel 78° bei einem Flankenwinkel von 59 ± 2 °C. Bei einem Versockelungswinkel von 78° ist eine ausreichende Stand-festigkeit der 200 μm Reliefpunkte nicht mehr gewährleistet.

### Vergleichsversuch 2

Es wird wie in Beispiel 2 verfahren, jedoch wie in Vergleichsversuch 1 ein Oberlack mit Phenolharz aufgetragen.

Die Mindestbelichtungszeit gemäß 1.4 beträgt 14 min, der Versockelungswinkel ca. 90°.

Wird wie in Beispiel 2 nur 10 min belichtet, so beträgt der Versockelungswinkel ca. 78° bei einem Flankenwinkel von 59 ± 2°.

### Vergleichsversuch 3

Es wird wie in Beispiel 1 verfahren, jedoch wie in Vergleichsversuch 1 ein Oberlack mit Phenolharz aufgetragen und zur Herstellung der Haftschicht HG ein Grundierlack verwandt, der anstelle des Epoxidharzes die gleiche Menge eines handelsüblichen hydroxylgruppenhaltigen, verzweigten Polyesters (OH-Zahl ca. 290, mittl. Molekulargewicht ca. 800) enthält und bei dem bei gleicher Gesamtmenge an Pigment der Lithopone-Anteil durch Rutil ersetzt ist. Zum resultierenden Stammlack werden 400 Teile eines handelsüblichen Umsetzungsproduktes als 1 Mol 1,1,1-Trimethylolpropan und 3 Molen Toluylendiisocyanat als Polyisocyanat (A3) in Form der 75 %igen Lösung in Xylol/Äthylglykolacetat (Teilverhältnis 1 : 1) eingemischt.

Die Mindestbelichtungszeit gemäß 1.4 beträgt 6 min, der Versockelungswinkel ca. 90°.

Wird wie in Beispiel 1 nur 3,5 min belichtet, so beträgt der Versockelungswinkel ca. 70° bei einem Flankenwinkel von 59 ± 2°.

### Vergleichsversuch 4

Es wird wie in Beispiel 2 verfahren, jedoch wie in Vergleichsversuch 1 ein Oberlack mit Phenolharz aufgetragen und zur Herstellung der Haftschicht HG der im Vergleichsversuch 3 angegebene Grundierlack verwandt.

Die Mindestbelichtungszeit gemäß 1.4 beträgt 17 min, der Versockelungswinkel ca. 90°.

Wird wie in Beispiel 2 nur 10 min belichtet, so beträgt der Versockelungswinkel ca. 70° bei einem Flankenwinkel von 59 ± 2°.

6

**Ansprüche**

1. Lichtempfindliches Mehrschichtenmaterial, das

a) zwischen einem Träger (T) und

b) einer lichtempfindlichen Schicht (R) mit einer Fotoinitiator enthaltenden in alkoholischem Lösungsmittel löslichen oder dispergierbaren Mischung von mindestens einem Polyamid-Bindemittel und mindestens einer damit verträglichen fotopolymerisierbaren ethylenisch ungesättigten niedermolekularen Verbindung,

c) eine dem Träger (T) benachbarte pigmentierte Haftschicht (HG) mit einem Umsetzungsprodukt eines hydroxylgruppenhaltigen Bindemittels mit einem Polyisocyanat und

d) eine den Schichten (HG) und (R) benachbarte Haftschicht (HO) mit einer eingebrannten Mischung eines Polyamid-Bindemittels, das mit dem Polyamid-Bindemittel der Schicht (R) verträglich ist, mit einem härtbaren Formaldehyd-Harz

aufweist, dadurch gekennzeichnet, daß

A) die Haftschicht (HG) durch Auftragen, Trocknen und Einbrennen eines Grundierlackes GL hergestellt ist, der als Feststoffe enthält :

A1) 20 bis 60 Gew.%, bezogen auf die Menge an Feststoffen A1-A4, eines Epoxidharz-Bindemittels mit einem mittleren Molekulargewicht von 900 bis 25 000 und einem Hydroxylgruppen-Gehalt von 4 bis 8 Gew.%,

A2) 0,8 bis 2 Äquivalente, bezogen auf 1 Äquivalent Hydroxylgruppen von (A1), eines Polyisocyanats,

A3) 15 bis 35 Gew.%, bezogen auf die Menge an Feststoffen A1-A4, einer Pigmentkombination aus

A3.1) einem Zinksulfid-Weißpigment, das bis zu 50 Gew.% durch Magnesiumoxid ersetzt sein kann,

A3.2) 0,05 bis 10 Gew.% der Pigmentkombination (A3), eines Titandioxid-Weißpigments und

A3.3) 0 bis 10 Gew.% der Pigmentkombination (A3) Chromoxidgrün-Pigment

A4) 0 bis 25 Gew.%, bezogen auf die Menge an Feststoffen A1-A4, mindestens eines Extenders, und

B) die Haftschicht (HO) als Bindemittel eine eingebrannte Mischung aus

B1) 65-98 Gew.% eines alkohollöslichen Copolyamids und

B2) 2 bis 35 Gew.% eines härtbaren alkoholveretherten Melamin-Formaldehyd-Kondensats mit einem mittleren Molekulargewicht von 300 bis 1 800 enthält.

2. Lichtempfindliches Mehrschichtenmaterial nach Anspruch 1, dadurch gekennzeichnet, daß die Pigmentkombination (A3) als Zinksulfid-Weißpigment Lithopone enthält.

3. Lichtempfindliches Mehrschichtenmaterial nach Anspruch 2, dadurch gekennzeichnet, daß die Pigmentkombination (A3) zu über 90 Gew.% aus Lithopone mit einem Zinksulfid-Gehalt von 60 Gew.% besteht.

4. Lichtempfindliches Mehrschichtenmaterial nach einem der Ansprüche 1 bis 3, dadurch gekennzeichnet, daß das Gewichtsverhältnis von Epoxidharz-Bindemittel (A1) zur Pigmentkombination (A3) 1 : 1 bis 2 : 1 beträgt.

5. Lichtempfindliches Mehrschichtenmaterial nach einem der Ansprüche 1 bis 4, dadurch gekennzeichnet, daß die Menge an Extender, bezogen auf die Gesamtmenge an Feststoffen A1-A4, 10 bis 20 Gew.% beträgt.

6. Lichtempfindliches Mehrschichtenmaterial nach einem der Ansprüche 1 bis 5, dadurch gekennzeichnet, daß der Grundierlack (GL) als Extender (A4) überwiegend Talkum aufweist.

7. Verfahren zur Herstellung von Haftschichten eines lichtempfindlichen Mehrschichtenmaterials, das zwischen

a) einem Träger (T) und

b) einer lichtempfindlichen Schicht R mit einer Fotoinitiator enthaltenden in alkoholischem Lösungsmittel löslichen oder dispergierbaren Mischung von mindestens einem Polyamid-Bindemittel und mindestens einer damit verträglichen fotopolymerisierbaren ethylenisch ungesättigten niedermolekularen Verbindung,

c) eine dem Träger (T) benachbarte pigmentierte Haftschicht (HG) mit einem Umsetzungsprodukt eines hydroxylgruppenhaltigen Bindemittels mit einem Polyisocyanat und

d) eine den Schichten (HG) und (R) benachbarte Haftschicht (HO) aufweist,

durch Auftragen eines Grundierlackes (GL) auf den Träger (T), wobei der Grundierlack (GL) ein hydroxylgruppenhaltiges Bindemittel (A1), ein Polyisocyanat (A2) sowie Pigment (A3) enthält, Trocknen und Einbrennen des Grundierlackes (GL) zur Haftschicht (HG) und anschließendes Auftragen eines Oberlackes (OL) auf die Haftschicht (HG), wobei der Oberlack (OL) ein Polyamid-Bindemittel, das mit dem Polyamid-Bindemittel der Schicht R verträglich ist, sowie ein härtbares Formaldehyd-Harz enthält, und Einbrennen des Oberlackes zur Haftschicht (HO), dadurch gekennzeichnet, daß der Grundierlack (GL) als Feststoff enthält :

A1) 20 bis 60 Gew.%, bezogen auf die Menge an Feststoffen A1-A4, eines Epoxidharz-Bindemittels mit einem mittleren Molekulargewicht von 900 bis 25 000 und einem Hydroxylgruppen-Gehalt von 4 bis 8 Gew.%,

A2) 0,8 bis 2 Äquivalente, bezogen auf 1 Äquivalent Hydroxylgruppen von (A1), eines Polyisocyanats,

A3) 15 bis 35 Gew.%, bezogen auf die Menge an Feststoffen A1-A4, einer Pigmentkombination aus

A3.1) einem Zinksulfid-Weißpigment, das bis zu 50 Gew.% durch Magnesiumoxid ersetzt sein kann,

A3.2) 0,05 bis 10 Gew.% der Pigmentkombination (A3) eines Titandioxid-Weißpigments, und

A3.3) 0 bis 10 Gew.% der Pigmentkombination (A3) Chromoxidgrün-Pigment,

A4) 0 bis 25 Gew.%, bezogen auf die Menge an Feststoffen A1-A4, mindestens eines Extenders, und

B) der Oberlack (OL) als Bindemittel eine Mischung aus

B1) 65 bis 98 Gew.% eines alkohollöslichen Copolyamids und

B2) 2 bis 35 Gew.% eines härtbaren alkoholveretherten Melamin-Formaldehyd-Kondensates mit einem mittleren Molekulargewicht von 300 bis 1 800

enthält.

## Claims

1. A photosensitive multi-layer material which possesses

a) between a base B and

b) a photosensitive layer R of a mixture — which is soluble or dispersible in an alcoholic solvent and contains a photoinitiator — of at least one polyamide binder and at least one photopolymerizable ethylenically unsaturated compound compatible therewith,

c) a pigmented adhesion-promoting layer APL adjacent to the base B and containing a reaction product of a hydroxyl-containing binder with a polyisocyanate, and

d) an adhesive layer AL adjacent to the layers APL and R and containing a baked mixture of a polyamide binder, which is compatible with the polyamide binder of layer R, and a hardenable formaldehyde resin,

wherein

A) the adhesion-promoting layer APL is prepared by applying, drying and baking a solution of reactive adhesive-forming compounds GL which contains, as solids

A1) from 20 to 60 % by weight, based on the amount of solids (A1)-(A4), of an epoxy resin binder having a mean molecular weight of from 900 to 25,000 and a hydroxyl content of from 4 to 8 % by weight,

A2) from 0.8 to 2 equivalents, per equivalent of hydroxyl groups of (A1), of a polyisocyanate,

A3) from 15 to 35 % by weight, based on the amount of solids (A1)-(A4), of a pigment combination of

A3.1) a white zinc sulfide pigment of which up to 50 % by weight can be replaced by magnesium oxide,

A3.2) from 0.05 to 10 % by weight, based on the pigment combination (A3), of a white titanium dioxide pigment and

A3.3) from 0 to 10 % by weight, based on the pigment combination (A3), of a chrome oxide green pigment, and

A4) from 0 to 25 % by weight, based on the amount of solids (A1)-(A4), of at least one extender, and

B) the adhesive layer AL contains, as binder, a baked mixture of

B1) from 65 of 98 % by weight of an alcohol-soluble copolyamide, and

B2) from 2 to 35 % by weight of a hardenable alcohol-etherified melamine-formaldehyde condensate having a mean molecular weight of from 300 to 1,800.

2. A photosensitive multi-layer material as claimed in claim 1, wherein the pigment combination (A3) contains lithopone as the white zinc sulphide pigment.

3. A photosensitive multi-layer material as claimed in claim 2, wherein the pigment combination (A3) contains more than 90 % by weight of lithopone which has a zinc sulfide content of 60 % by weight.

4. A photosensitive muli-layer material as claimed in any of claims 1 to 3, wherein the weight ratio of epoxy resin binder (A1) to pigment combination (A3) is from 1 : 1 to 2 : 1.

5. A photosensitive multi-layer material as claimed in any of claims 1 to 4, wherein the amount of extender is from 10 to 20 % by weight, based on the total amount of solids (A1)-(A4).

6. A photosensitive multi-layer material as claimed in any of claims 1 to 5, wherein the extender (A4) contained in the solution of reactive adhesive-forming compounds GL predominantly consists of talc.

7. A process for the preparation of adhesive layers of a photosensitive multi-layer material which possesses

a) between a base B and

b) a photosensitive layer R of a mixture — which is soluble or dispersible in an alcoholic solvent and contains a photoinitiator — of at least one polyamide binder and at least one photopolymerizable ethylenically unsaturated compound compatible therewith,

c) a pigmented adhesion-promoting layer APL adjacent to the base B and containing a reaction product of a hydroxylcontaining binder with a polyisocyanate, and

d) an adhesive layer AL adjacent to the layers APL and R,

by applying a layer of a solution of reactive adhesive-forming compounds GL to the base B, the solution GL containing a hydroxyl-containing binder (A1), a polyisocyanate (A2) and pigment (A3) ; drying and baking the layer of solution GL to form the adhesion-promoting layer APL ; and then applying a layer of a hardenable mixture OL to the adhesion-promoting layer APL, the mixture OL containing both a polyamide binder, which is compatible with the polyamide binder of layer R, and a curable formaldehyde resin ; and baking the layer of hardenable mixture OL to form the adhesive layer AL, wherein the solution of reactive adhesive-forming compounds GL contains, as solids :

A1) from 20 to 60 % by weight, based on the amount of solids (A1)-(A4), of an epoxy resin binder having a mean molecular weight of from 900 to 25,000 and a hydroxyl content of from 4 to 8 % weight,

A2) from 0.8 to 2 equivalents, per equivalent of hydroxyl groups of (A1), of a polyisocyanate,

A3) from 15 to 35 % by weight, based on the amount of solids (A1)-(A4), of a pigment combination of

A3.1) a white zinc sulfide pigment of which up to 50 % by weight can be replaced by magnesium oxide,

A3.2) from 0.05 to 10 % by weight, based on the pigment combination (A3), of a white titanium dioxide pigment and

A3.3) from 0 to 10 % by weight, based on the pigment combination (A3), of a chrome oxide green pigment, and

A4) from 0 to 25 % by weight, based on the amount of solids (A1)-(A4), of at least one extender, and

B) the hardenable mixture OL contains, as binder, a mixture of

B1) from 65 to 98 % by weight of an alcohol-soluble copolyamide, and

B2) from 2 to 35 % by weight of a hardenable, alcohol-etherified melamine-formaldehyde condensate having a mean molecular weight of from 300 to 1,800.


**Revendications**

1. Matériau photosensible multicouche, qui comporte :

a) entre un support (T) et

b) une couche (R) photosensible, comprenant un mélange, soluble ou dispersable en solvant alcoolique et contenant un photoinitiateur, d'au moins un liant polyamide et au moins un composé à bas poids moléculaire, à insaturation éthylénique, photopolymérisable et compatible avec lui

c) une couche d'adhérence (HG) pigmentée, voisine du support (T), comprenant un produit de réaction d'un liant à groupes hydroxyle et d'un polyisocyanate, et

d) une couche d'adhérence (HO), voisine des couches (HG) et (R), comprenant un mélange cuit, d'un liant polyamide compatible avec le liant polyamide de la couche (R), et d'une résine formaldéhyde durcissable,

caractérisé par le fait que :

A) la couche d'adhérence (HG) est préparée par application, séchage et cuisson d'une couche de vernis de fond GL qui contient, comme matières solides :

A1) 20 à 60 % en poids, rapportés à la quantité de matières solides A1-A4, d'un liant de résine époxy d'un poids moléculaire moyen de 900 à 25 000 et d'une teneur en groupes hydroxyle de 4 à 8 % en poids,

A2) 0,8 à 2 équivalents, pour 1 équivalent de groupes hydroxyle de (A1), d'un polyisocyanate,

A3) 15 à 35 % en poids, rapportés à la quantité de matières solides A1-A4, d'une combinaison de pigments faite de

A3.1) un pigment blanc au sulfure de zinc, qui peut être remplacé, jusqu'à 50 % en poids, par de l'oxyde de magnésium,

A3.2) 0,05 à 10 % en poids de la combinaison de pigments (A3), d'un pigment blanc au dioxyde de titane et

A3.3) 0 à 10 % en poids de la combinaison de pigments (A3), de pigment vert à l'oxyde de chrome,

A4) 0 à 25 % en poids, rapportés à la quantité de matières solides A1-A4, d'au moins un extendeur, et

B) la couche d'adhérence (HO) contient, comme liant, un mélange cuit de

B1) 65 à 98 % en poids d'un copolyamide alcoolique et

B2) 2 à 35 % en poids d'un condensat mélamine-formaldéhyde éthérifié à l'alcool, durcissable, d'un poids moléculaire moyen de 300 à 1 800.

2. Matériau photosensible à plusieurs couches, selon la revendication 1, caractérisé par le fait que la combinaison de pigments (A3) contient, comme pigment blanc au sulfure de zinc, du lithopone.

3. Matériau photosensible à plusieurs couches, selon la revendication 2, caractérisé par le fait que la combinaison de pigments (A3) est constituée, jusqu'à plus de 90 % en poids, de lithopone à teneur en sulfure de zinc de 60 % en poids.

4. Matériau photosensible à plusieurs couches, selon l'une des revendications 1 à 3, caractérisé par le fait que le rapport en poids du liant de résine époxy (A1) à la combinaison de pigments (A3) est de 1/1 à 2/1.

5. Matériau photosensible à plusieurs couches, selon l'une des revendications 1 à 4, caractérisé par le fait que la quantité d'extendeur, rapportée à la quantité totale de matières solides A1-A4, est de 10 à 20 % en poids.

6. Matériau photosensible à plusieurs couches, selon l'une des revendications 1 à 5, caractérisé par le fait que la couche de fond (GL) comprend, comme extendeur (A4), surtout du talc.

7. Procédé de préparation de couches d'adhérence d'un matériau photosensible multicouche, qui comporte :

a) entre un support (T) et

b) une couche (R) photosensible, comprenant un mélange, soluble ou dispersable en solvant alcoolique et contenant un photoinitiateur, d'au moins un liant polyamide et au moins un composé à bas poids moléculaire à insaturation éthylénique, photopolymérisable et compatible avec lui

c) une couche d'adhérence (HG) pigmentée, voisine du support (T), comprenant un produit de réaction d'un liant à groupes hydroxyle et d'un polyisocyanate, et

d) une couche d'adhérence (HO) voisine des couches (HG) et (R)

par application d'une couche de peinture de fond (GL) sur le support (T), la couche de fond (GL) contenant un liant (A1) à groupes hydroxyle, un polyisocyanate (A2) ainsi qu'un pigment (A3), séchage et cuisson de la couche de fond (GL) pour obtenir une couche d'adhérence (HG), ensuite application d'une couche de peinture de dessus (finish) (OL) sur la couche d'adhérence (HG), la couche de dessus (OL) contenant un haut polyamide, compatible avec le liant polyamide de la couche R, ainsi qu'une résine formaldéhyde durcissable, et cuisson de la couche de dessus pour obtenir la couche d'adhérence (HO), caractérisé par le fait que la couche de fond (GL) contient, comme matière solide :

A1) 20 à 60 % en poids, rapportés à la quantité de matières solides A1-A4, d'un liant de résine époxy d'un poids moléculaire moyen de 900 à 25 000 et d'une teneur en groupes hydroxyle de 4 à 8 % en poids,

A2) 0,8 à 2 équivalents, pour 1 équivalent de groupes hydroxyle de (A1), d'un polyisocyanate,

A3) 15 à 35 % en poids, rapportés à la quantité de matières solides A1-A4, d'une combinaison de pigments faite de

A3.1) un pigment blanc au sulfure de zinc, qui peut être remplacé, jusqu'à 50 % en poids, par de l'oxyde de magnésium,

A3.2) 0,05 à 10 % en poids de la combinaison de pigments (A3), d'un pigment blanc au dioxyde de titane et

A3.3) 0 à 10 % en poids de la combinaison de pigments (A3) de pigment vert à l'oxyde de chrome

A4) 0 à 25 % en poids, rapportés à la quantité de matières solides A1-A4, d'au moins un extendeur, et

B) la couche de dessus (OL) contient, comme liant, un mélange de

B1) 65 à 98 % en poids d'un copolyamide alcoolique et

B2) 2 à 35 % en poids d'un condensat mélamine-formaldéhyde éthérifié à l'alcool, durcissable, d'un poids moléculaire moyen de 300 à 1 800.